Europäisches Patentamt

European Patent Office

Office européen des brevets

(11) Numéro de publication : **0 431 512 B1**

# (12) FASCICULE DE BREVET EUROPEEN

(45) Date de publication du fascicule du brevet :
05.01.94 Bulletin 94/01

(51) Int. Cl.⁵ : **G01R 15/06,** G01R 19/165

(21) Numéro de dépôt : **90123076.3**

(22) Date de dépôt : **03.12.90**

(54) **Dispositif de mesure de tension.**

(30) Priorité : **07.12.89 FR 8916189**

(43) Date de publication de la demande :
**12.06.91 Bulletin 91/24**

(45) Mention de la délivrance du brevet :
**05.01.94 Bulletin 94/01**

(84) Etats contractants désignés :
**AT BE CH DE DK ES FR GB GR IT LI LU NL SE**

(56) Documents cités :
**DE-A- 2 162 723
DE-A- 2 227 420
FR-A- 2 437 626**

(73) Titulaire : **GEC ALSTHOM SA
38, avenue Kléber
F-75116 Paris (FR)**

(72) Inventeur : **Moncorge, Jean-Paul
30 Chemin de la Rize
F-69120 Vaux en Velin (FR)**

(74) Mandataire : **Weinmiller, Jürgen et al
Lennéstrasse 9 Postfach 24
D-82336 Feldafing (DE)**

EP 0 431 512 B1

## Description

La présente invention est relative à un dispositif de mesure de tension, utilisé dans les équipements de mesure et de protection des réseaux électriques.

Il a été décrit, dans le document FR-A-2 437 626, un réducteur de tension électronique suivi de deux circuits d'amplification: l'un de ces circuits a une constante de temps relativement élevée, de l'ordre de la centaine de millisecondes, et sert à alimenter les organes de mesure, pour lesquels on n'exige pas un temps de rétablissement rapide en cas de disparition de la tension. L'autre circuit d'amplification a une constante de temps beaucoup plus courte, de l'ordre de la dizaine de millisecondes, car il sert à alimenter des organes de protection pour lesquels on exige un temps de rétablissement rapide. Un tel appareil comprend donc deux chaînes de mesure et un but de la présente invention est de réaliser un dispositif ne comportant qu'une seule sortie de mesure; un tel appareil est à l'évidence plus économique que celui de l'art antérieur.

L'invention a ainsi pour objet un dispositif de mesure de tension d'une ligne électrique comprenant, pour chaque phase de la ligne, un diviseur capacitif comportant un premier condensateur relié à la ligne et en série avec un second condensateur relié à la terre, et une première et une seconde lignes d'amplification de la tension aux bornes du second condensateur, ladite première ligne ayant une constante de temps de l'ordre de la centaine de millisecondes et étant associée à un circuit correcteur de phase, ladite seconde ligne d'amplification ayant une constante de temps de 2,5 à 15 millisecondes, caractérisé en ce que les première et seconde lignes d'amplification sont reliées à une sortie commune respectivement à travers un premier et un second interrupteurs commandables par un circuit logique, le dispositif de mesure comprenant en outre un circuit pour élaborer un signal représentatif de la valeur absolue de la différence algébrique entre les signaux fournis respectivement par les première et seconde lignes d'amplification, un circuit comparateur recevant le signal précité et fournissant en sortie un ordre de commande audit circuit logique lorsque ladite valeur absolue franchit un seuil donné, ledit circuit logique étant agencé pour maintenir fermé le premier interrupteur et ouvert le second interrupteur lorsque ladite valeur est inférieure audit seuil et commander l'ouverture du premier interrupteur et la fermeture du second interrupteur lorsque ladite valeur franchit le seuil.

Avantageusement, le circuit logique est temporisé.

La temporisation du circuit logique est de l'ordre de 50 millisecondes.

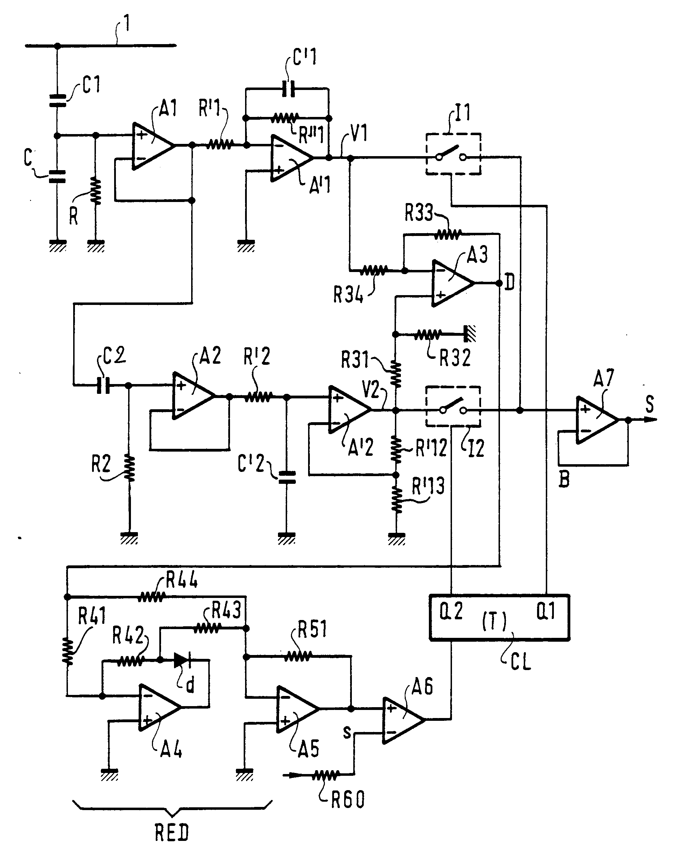

L'invention sera bien comprise par la description donnée ci-après d'un mode préféré de réalisation de l'invention, en référence au dessin annexé dans lequel la figure unique est un schéma synoptique du circuit de l'invention, limité à une phase.

Dans la figure, la référence 1 désigne une phase d'une ligne électrique à haute tension, à laquelle est relié un diviseur capacitif comprenant un premier condensateur C1, en série avec un second condensateur C relié par ailleurs à la terre.

Le circuit électronique comprend un amplificateur opérationnel A1 dont le circuit d'entrée comprend une résistance R. La valeur de R est choisie de telle sorte que la constante de temps du circuit RC soit relativement élevée, de l'ordre de la centaine de millisecondes. La sortie de l'amplificateur A1 est connectée à deux lignes: la première ligne comprend un amplificateur A'1 et un premier interrupteur I1; la seconde ligne comprend un amplificateur A2, un amplificateur A'2 et un second interrupteur I2. Les deux lignes se rejoignent à l'entrée d'un amplificateur de sortie A7 dont la sortie S alimente les appareils de mesure et les organes de protection de la ligne.

L'amplificateur A'1 est relié à la sortie de l'amplificateur A1 par une résistance R'1 et il comprend en parallèle une capacité C'1 et une résistance R"1. L'amplificateur A'1 et ses composants associés constituent un correcteur de phase permettant d'obtenir par exemple une précision de classe 0,5 (20 minutes d'angle maximum de déphasage entre 48 et 51 Hertz). Les valeurs de R'1, R"1 et C'1 sont choisies pour donner à l'amplificateur opérationnel A'1 une constante de temps élevée, de l'ordre de 0,1 seconde, de sorte que la constante de temps de la première ligne est celle de l'amplificateur A1. Cette constante de temps élevée, associée à la correction de phase, permet l'obtention d'un signal de mesure tout à fait approprié à l'alimentation d'appareils de mesure de tension de la ligne. L'interrupteur I1 est un interrupteur à semi-conducteur ou un relais.

L'amplificateur A2 est attaqué par un circuit d'entrée comportant un condensateur C2 et une résistance R2 de valeurs choisies pour que la seconde ligne ait une constante de temps beaucoup plus faible que celle de la première ligne, par exemple comprise entre 2,5 et 15 millisecondes. On choisira par exemple une valeur de 10 millisecondes lorsque la plage de variation de fréquence de la ligne est comprise entre 48 et 51 Hz. Cette faible constante de temps est nécessaire pour la commande des organes de protection de la ligne. Le circuit à résistance R'2 et condensateur C'2 sert de correcteur de phase. L'amplificateur A'2, associé aux résistances R'12 et R'13, est un amplificateur de puissance. L'interrupteur I2 est, comme l'interrupteur I1, un interrupteur commandable à semi-conducteur ou un relais.

Les sorties respectives des amplificateurs A'1 et A'2 sont reliées aux deux entrées d'un amplificateur opérationnel A3, respectivement par les résistances R34 et R31. L'amplificateur A3 est monté en soustracteur, grâce à deux résistances R32 et R33, et fournit

la différence algébrique D = V1 - V2 des signaux de sortie des amplificateurs A'1 et A'2.

Le signal D est envoyé sur un circuit redresseur à deux alternances RED comprenant un amplificateur opérationnel A4 monté avec des résistances R41 à R44 et une diode d, et un amplificateur opérationnel A5 monté avec une résistance R51. Le circuit RED fournit donc en sortie la valeur absolue /V1 -V2/ de la différence algébrique V1 - V2. La sortie du circuit redresseur RED est connectée à une entrée d'un comparateur A6 recevant par ailleurs sur une autre entrée, par une résistance R60, un signal de seuil s. La sortie du comparateur A6 est reliée à un circuit logique à deux sorties complémentaires Q1 et Q2 commandant respectivement les interrupteurs I1 et I2. Ce circuit logique CL est agencé pour que, si le comparateur A6 ne délivre aucun signal, ( /V1 - V2/ < s ), la sortie Q1 soit activée et l'interrupteur I1 fermé. Au contraire, si le comparateur détecte une différence entre V1 et V2 supérieure à la valeur de seuil s, la sortie Q2 est activée, l'interupteur I1 s'ouvre et l'interrupteur I2 se ferme. Le circuit CL est équipé d'une temporisation, par exemple de 50 millisecondes, dont le rôle sera expliqué plus loin.

Le fonctionnement du circuit est le suivant:

- en régime permanent et normal, les signaux V1 et V2 sont égaux, de sorte que le comparateur A6 ne fournit aucun signal. La sortie Q1 du circuit CL est alors par construction activée et la ligne A1, A'1 est en service, permettant des mesures avec la précision nécessaire.

- en cas de réenclenchement sur une ligne chargée, les tensions de sortie V1 et V2 des deux lignes vont comporter une composante dite continue qui s'amortirait exponentiellement, pour la première ligne en 100 ms et pour la seconde ligne en 10 ms. Les signaux V1 et V2 seront donc différents, et dès que leur différence atteindra la valeur de seuil, le circuit logique CL basculera, entraînant l'ouverture de l'interrupteur I1 et la fermeture de l'interrupteur I2. La deuxième ligne d'amplification sera donc mise en service, avec sa faible constante de temps qui va éliminer très rapidement la composante exponentielle nuisible, qui en particulier sature le transformateur de l'amplificateur de puissance qui suit le préamplificateur.

La temporisation à la retombée évite des commutations répétées quand la différence V1 - V2 s'approche du seuil s.

Ce seuil doit être supérieur à l'erreur d'étalonnage qu'il peut y avoir entre les deux sorties de ligne (à 50 Hz) augmentée de l'écart de dérive en fréquence aux limites de la bande (48 - 51 Hz).

Le circuit de l'invention présente l'avantage d'être plus simple que celui de l'art antérieur. En régime normal, l'erreur de phase de la mesure est faible.

En cas de réenclenchement sur ligne chargée, la composante continue est éliminée très rapidement.

Il est possible d'ajuster à la fois la valeur de seuil s et la valeur de la temporisation pour optimiser le fonctionnement. La première ligne d'amplification (constante de temps de l'ordre de 100 ms) est idéale pour transmettre les transitoires dus à une autre cause qu'un réenclenchement sur ligne chargée. Si on place la valeur de seuil s assez haut, on pourra mesurer ces transitoires sans faire basculer le circuit CL.

Dans le cas où l'excursion de la fréquence de la ligne est réduite (par exemple de 49,5 à 50,5 Hz), la meilleure réponse en régime transitoire, avec réenclenchement sur ligne chargée, est obtenue en utilisant une constante de temps R2C2 égale a 3,18 ms (au lieu de 10 ms). La constante de temps R'2C'2 est alors aussi égale à 3,18 ms. (3,18 ms = 1/(2 $\pi$ fo), avec fo = 50 Hz).

A 60 Hz, 3,18 ms est remplacé par 2,65 ms.

L'invention trouve application dans l'exploitation et la protection des réseaux électriques.

**Revendications**

1. Dispositif de mesure de tension d'une ligne électrique comprenant, pour chaque phase de la ligne, un diviseur capacitif comportant un premier condensateur (C1) relié à la ligne et en série avec un second condensateur (C) relié à la terre, et une première (A1, A'1) et une seconde (A1, A2, A'2) lignes d'amplification de la tension aux bornes du second condensateur (C), ladite première ligne (A1, A'1) ayant une constante de temps de l'ordre de la centaine de millisecondes et étant associée à un circuit correcteur de phase (A'1, R'1, R''1, C'1), ladite seconde ligne d'amplification (A1, A2, A'2) ayant une constante de temps de 2,5 à 15 millisecondes, caractérisé en ce que les première (A1, A'1) et seconde (A1, A2, A'2) lignes d'amplification sont reliées a une sortie commune (5) respectivement à travers un premier (I1) et un second (I2) interrupteurs commandables par un circuit logique (CL), le dispositif de mesure comprenant en outre un circuit (A3, RED) pour élaborer un signal représentatif de la valeur absolue de la différence algébrique (D) entre les signaux fournis respectivement par les première (A1, A'1) et seconde (A1, A2, A'2) lignes d'amplification, un circuit comparateur (A6) recevant le signal précité et fournissant en sortie un ordre de commande audit circuit logique (CL) lorsque ladite valeur absolue franchit un seuil donné s , ledit circuit logique étant agencé pour maintenir fermé le premier interrupteur (I1) et ouvert le second interrupteur (I2) lorsque ladite valeur est inférieure audit seuil et commander l'ouverture du premier interrupteur (I1) et la fermeture du second interrupteur (I2) lorsque ladite valeur franchit le seuil.

2. Dispositif selon la revendication 1, caractérisé en ce que, lorsque la plage de variation de la fréquence de la ligne est comprise entre 49,5 et 50,5 Hz, la constante de temps de la deuxième (A1, A2, A'2) ligne d'amplification est voisine de 3,18 millisecondes.

3. Dispositif selon la revendication 1, caractérisé en ce que, lorsque la plage de variation de la fréquence de la ligne est comprise entre 59,5 et 60,5 Hz, la constante de temps de la deuxième ligne d'amplification (A1, A2, A'2) est voisine de 2,65 millisecondes.

4. Dispositif de mesure selon l'une des revendications 1 à 3, caractérisé en ce que le circuit logique (CL) est temporisé.

5. Dispositif selon la revendication 4, caractérisé en ce que la temporisation du circuit logique (CL) est de l'ordre de 50 millisecondes.

**Patentansprüche**

1. Vorrichtung zur Messung der Spannung auf einer elektrischen Leitung, mit einem kapazitiven Teiler je Phase der Leitung, bestehend aus einem ersten an die Leitung angeschlossenen Kondensator (C1) in Reihe mit einem zweiten an Erde angeschlossenen Kondensator (C), und mit einem ersten (A1, A'1) und einem zweiten Pfad (A1, A2, A'2) zur Verstärkung der Spannung an den Ausgängen des zweiten Kondensators (C), wobei der erste Pfad (A1, A'1) eine Zeitkonstante in der Größenordnung von 100 ms besitzt und einem Phasenkorrekturkreis (A'1, R'1, R''1, C'1) zugeordnet ist, während der zweite Verstärkungspfad (A1, A2, A'2) eine Zeitkonstante zwischen 2,5 und 15 ms besitzt, dadurch gekennzeichnet, daß der erste (A1, A'1) und der zweite Verstärkungspfad (A1, A2, A'2) an einen gemeinsamen Ausgang (S) über einen ersten (I1) bzw. einen zweiten von einer logischen Schaltung (CL) steuerbaren Schalter (I2) angeschlossen sind, wobei die Meßvorrichtung außerdem eine Schaltung (A3, RED), um ein für den Absolutwert der algebraischen Differenz (D) zwischen den vom ersten (A1, A'1) und vom zweiten Verstärkungspfad (A1, A2, A'2) gelieferten Signalen charakteristisches Signal zu erarbeiten, und eine Komparatorschaltung (A6) enthält, die das erwähnte Signal empfängt und am Ausgang einen Steuerbefehl für die logische Schaltung (CL) liefert, wenn dieser Absolutwert eine gegebene Schwelle s überschreitet, wobei die logische Schaltung so ausgebildet ist, daß sie den ersten Schalter (I1) geschlossen hält und den zweiten Schalter (I2) offen hält, wenn der Wert unter dieser Schwelle liegt, und daß der erste Schalter (I1) geöffnet und der zweite Schalter (I2) geschlossen wird, wenn der Wert die Schwelle überschreitet.

2. Vorrichtung nach Anspruch 1, dadurch gekennzeichnet, daß die Zeitkonstante des zweiten Verstärkungspfads (A1, A2, A'2) bei etwa 3,18 ms liegt, wenn die Frequenz der Leitung zwischen 49,5 und 50,5 Hz variieren kann.

3. Vorrichtung nach Anspruch 1, dadurch gekennzeichnet, daß die Zeitkonstante des zweiten Verstärkungspfads (A1, A2, A'2) bei etwa 2,65 ms liegt, wenn die Frequenz der Leitung zwischen 59,5 und 60,5 Hz variieren kann.

4. Vorrichtung zur Messung nach einem der Ansprüche 1 bis 3, dadurch gekennzeichnet, daß die logische Schaltung (CL) eine Haltezeit besitzt.

5. Vorrichtung nach Anspruch 4, dadurch gekennzeichnet, daß die Haltezeit der logischen Schaltung (CL) in der Größenordnung von 50 ms liegt.

**Claims**

1. A circuit for measuring the tension of an electricity line, the circuit comprising, for each phase of the line: a capacitive tension divider comprising a first capacitor (C1) connected to the line and in series with a second capacitor (C) connected to ground; and first and second (A1, A'1; A1, A2, A'2) amplification lines for amplifying the tension across the terminal of the second capacitor (C), said first amplification line (A1, A'1) having a time constant of the order of 100 ms and being associated with a phase correcting circuit (A'1, R'1, R''1, C'1), said second amplification line (A1, A2, A'2) having a time constant of 2.5 ms to 15 ms; the tension measuring circuit being characterized in that the first and second amplification lines (A1, A'1; A1, A2, A'2) are connected to a common output (S) respectively via first and second switches (I1, I2) controllable by a logic circuit (CL), the tension measuring circuit further including a circuit (A3, RED) for generating a signal representative of the absolute value of the algebraic difference (D) between the respective signals provided by the first and second amplification lines (A1, A'1; A1, A2, A'2), a comparator circuit (A6) receiving said signal and providing at its output a control signal for said logic circuit (CL) causing it to operate when said absolute value exceeds a given threshold (s), said logic circuit being connected to keep the first switch (I1) closed and the second switch (I2) open so long as said absolute value is less than said threshold, and to open the first switch (I1) and to close the second switch (I2) when said absolute value exceeds the threshold.

2. A circuit according to claim 1, characterized in that when the range of frequency variation of the electricity line is 49.5 Hz to 50.5 Hz, the time constant of the second amplification line (A1, A2, A'2) is about 3.18 ms.

3. A circuit according to claim 1, characterized in that when the range of frequency variation on the electricity line is 59.5 Hz to 60.5 Hz, the time constant of the second amplification line (A1, A2, A'2) is about 2.65 ms.

4. A circuit according to any one of claims 1 to 3, characterized in that the logic circuit (CL) includes a time delay.

5. A circuit according to claim 4, characterized in that the time delay of the logic circuit (CL) is of the order of 50 ms.